# EUROPÄISCHE PATENTSCHRIFT

(11) **EP 1 220 146 B1**
(45) Veröffentlichungstag und Bekanntmachung des Hinweises auf die Patenterteilung: **19.08.2009**
(21) Anmeldenummer: 01126905.7
(22) Anmeldetag: 13.11.2001
(51) Int. Cl.: G06K 15/12, B41J 2/47, H01S 5/0683

(54) **Verfahren zur thermischen Stabilierung einer Laserdiode in einem Recorder**
Thermal stabilisation method of a laser diode in a recorder
Méthode de stabilisation thermique d'une diode à laser dans un dispositif d'enregistrement

(30) Priorität: 20.12.2000 DE 10063707
(43) Veröffentlichungstag der Anmeldung: 03.07.2002
(73) Patentinhaber: Heidelberger Druckmaschinen Aktiengesellschaft, 69115 Heidelberg (DE)
(72) Erfinder: Fischer, Jörg-Achim, 24235 Laboe (DE); Leiss, Klaus-Günter, 24107 Kiel (DE)

(56) Entgegenhaltungen:
- EP-A- 0 963 016
- US-A- 5 309 458
- US-A- 5 341 156
- US-A- 5 495 463

## Beschreibung

Die Erfindung bezieht sich auf das Gebiet der elektronischen Reproduktionstechnik und betrifft ein Verfahren zur thermischen Stabilisierung einer Laserdiode bei der punkt- und zeilenweisen Belichtung von Aufzeichnungsmaterial mittels eines Lichtstrahls in einer elektronischen Belichtungsvorrichtung, auch Belichter, Recorder oder Imagesetter genannt. Mit einem Recorder werden insbesondere Druckformen belichtet, d.h. Filme oder Druckplatten, die alle Text-, Grafik- und Bildelemente einer zu druckenden Seite enthalten. Im Fall des Mehrfarbendrucks wird für jede Druckfarbe eine separate Druckform belichtet.

In einem Recorder wird ein durch ein Bildsignal modulierter Lichtstrahl punktund zeilenweise über das zu belichtende Aufzeichnungsmaterial geführt. Das Aufzeichnungsmaterial ist dabei auf einer Halterung fixiert, die sich relativ zum Lichtstrahl bewegt. Im Falle eines Innentrommel-Gerätes ist das Aufzeichnungsmaterial auf einer zylindersegmentförmigen Halterung oder Belichtungsmulde fixiert, und der Lichtstrahl wird mittels einer rotierenden Lichtstrahl-Ablenkvorrichtung punkt- und zeilenweise über das Aufzeichnungsmaterial geführt. Der Recorder kann aber auch als Außentrommel-Gerät oder Flachbett-Gerät ausgebildet sein.

Als Lichtquelle zur Erzeugung des Lichtstrahles wird häufig eine Laserdiode verwendet, die mit dem Bildsignal moduliert wird. In der herkömmlichen Drucktechnik werden unterschiedliche Dichten einer Druckfarbe durch Rasterpunkte mit variierender Größe erzeugt, d.h. an jedem Punkt der Druckseite wird entweder Farbe gedruckt oder nicht. Deshalb hat das Bildsignal nur zwei Signalwerte, Farbe oder Nicht-Farbe bzw. Belichtung oder Nicht-Belichtung. Dementsprechend wird die Laserdiode bei der Belichtung so moduliert, daß sie für die zu belichtenden Bildpunkte Licht aussendet und für die nicht zu belichtenden Bildpunkte kein Licht aussendet. Die Ansteuerung der Laserdiode durch das Bildsignal erfolgt nach dem Stand der Technik derart, daß sie zeilenweise innerhalb von Belichtungszeiträumen, in denen der Lichtstrahl die zu belichtenden Zeilen auf dem Aufzeichnungsmaterial überstreicht, aktiviert und moduliert wird und innerhalb von Rückführungszeiträumen, in denen der Lichtstrahl zu der nächsten zu belichtenden Zeile geführt wird, deaktiviert wird.

Ein bekanntes Problem bei der Belichtung mit einer Laserdiode ist, daß sich die abgegebene Lichtleistung und auch die Wellenlänge mit der Temperatur der Laserdiode ändert. Dabei gelten unterschiedliche Zeitkonstanten für die Temperaturänderung, sehr kurze Zeitkonstanten, wenn sich die Temperatur des PN-Übergangs in der Laserdiode durch das Ein- und Ausschalten des Modulationsstroms sehr schnell ändert, mittlere Zeitkonstanten, wenn sich die Temperatur von Aufbauteilen der Laserdiode durch eine variierende mittlere Strombelastung verändert, und eine lange Zeitkonstante, wenn sich beispielsweise die Umgebungstemperatur ändert. In der Regel können die kurzen, mittleren und langen Zeitkonstanten nicht klar abgegrenzt werden, sondern es gibt einen gleitenden Übergang zwischen den Temperaturabhängigkeiten mit unterschiedlichen Zeitkonstanten. Das ist im Einzelfall stark abhängig vom Aufbau der Laserdiode, d.h. von der mechanisch-thermischen Anbindung des Laserchips an eine Trägerplatte und die thermische Kopplung über weitere Aufbauteile bis hin zum Gehäuse. Außerdem werden die Temperaturzeitkonstanten von der konstruktiven Gestaltung des Einbaus der Laserdiode in den Recorder, von der Wärmeableitung über die Bauteile des Recorders und von der Lüftung beeinflußt.

Für die Belichtung von Druckformen ist eine konstante Lichtleistung unabdingbar, da sich Schwankungen der Lichtleistung in unerwünschten Streifen, Mustern usw. in der fertig belichteten Druckform bemerkbar machen. Des weiteren kann eine sich infolge von Temperaturschwankungen verändernde Wellenlänge ähnliche störende Muster hervorrufen, je nach der Abhängigkeit der Belichtungsempfindlichkeit des Aufzeichnungsmaterials von der Wellenlänge des Lichts.

Für die Kompensierung von sehr kurzzeitigen Leistungsschwankungen, die schon durch die Temperaturänderung des PN-Übergangs der Laserdiode während eines einzelnen Modulationsimpulses auftreten, ist ein Verfahren bekannt, bei dem der durch die Temperaturerhöhung bedingte Leistungsabfall bzw. die durch eine Temperatursenkung bedingte Leistungssteigerung durch einen zusätzlichen Korrekturstrom ausgeglichen wird. Dabei wird der zeitliche Verlauf der Leistungsänderung durch einen entsprechend gegenläufigen Verlauf des Korrekturstroms kompensiert, wobei der Zeitverlauf durch ein Widerstands-Kapazitäts-Netzwerk im Stromgenerator für den Korrekturstrom nachgebildet wird. Ein solches Verfahren ist in der amerikanischen Patentschrift US 5,309,458 beschrieben.

Für die Kompensierung von Leistungsschwankungen mit mittleren und langen Zeitkonstanten wird nach dem Stand der Technik eine Regelung der Lichtleistung eingesetzt, wobei ein Teil des Lichtstrahls aus dem Belichtungsstrahlengang ausgekoppelt und auf einen Lichtsensor gelenkt wird. Die mit dem Lichtsensor gemessene Lichtleistung wird als Meßgröße in einen Regelkreis eingegeben, der die Leistung der Laserdiode auf einen vorgegebenen Wert regelt. Dazu wird zum Beispiel während einer Regelphase vor jeder Modulationsphase die Lichtleistung bei einem vorgegebenen Laserdiodenstrom gemessen und die Laserleistung geregelt. Ein solches Verfahren ist in der amerikanischen Patentschrift US 5,495,463 beschrieben.

Das Regelverfahren ist vorwiegend zum Kompensieren von relativ langsamen Temperaturänderungen von Modulationsphase zu Modulationsphase geeignet. Im Fall eines Recorders für Druckformen entspricht eine zu belichtende Zeile einer Modulationsphase. Das Regelverfahren kann nur vor jeder zu belichtenden Zeile eingreifen und Abweichungen kompensieren. Das Regelverfahren ist außerdem aufwendig in der Realisierung, besonders wenn auch Leistungsschwankungen von Zeile zu Zeile ausgeregelt werden sollen, die durch die vom Bildinhalt abhängige Zahl und auch die innerhalb der Zeilen variierende Verteilung der zu belichtenden Bildpunkte hervorgerufen werden. Das Korrekturstromverfahren ist nur für sehr kurze Leistungsschwankungen im Zeitbereich von einem oder wenigen Bildpunkten geeignet und kann deshalb nicht die Leistungsschwankungen mit einer mittleren Zeitkonstante kompensieren.

Es ist daher die Aufgabe der vorliegenden Erfindung, ein Verfahren zur Belichtung von Aufzeichnungsmaterial mit einer Laserdiode derart zu verbessern, daß auf einfache Weise eine thermische Stabilisierung der Laserdiodenleistung im Bereich mittlerer Zeitkonstanten erreicht wird.

Diese Aufgabe wird durch die Merkmale des Anspruchs 1 gelöst. Vorteilhafte Weiterbildungen und Ausgestaltungen sind in den Unteransprüchen angegeben.

Die Erfindung wird nachfolgend anhand der Figuren 1 bis 7 näher erläutert. Es zeigen:
- Fig. 1: die Modulation einer Laserdiode in einem Strom-Leistungs-Diagramm,
- Fig. 2: eine prinzipielle Darstellung einer Belichtungsvorrichtung vom Innentrommel-Typ im Schnittbild,
- Fig. 3: Zeitdiagramme für den Basisstrom und den Modulationsstrom nach dem Stand der Technik,
- Fig. 4: Zeitdiagramme für den Basisstrom und den Modulationsstrom gemäß der Erfindung,
- Fig. 5: Zeitdiagramme für den Basisstrom und den Modulationsstrom während der Belichtungsvorbereitung und während der Belichtung,
- Fig. 6: Zeitdiagramme für den Basisstrom und den Modulationsstrom nach einem weiteren Merkmal der Erfindung, und
- Fig. 7: Zeitdiagramme für den Basisstrom und den Modulationsstrom für eine weitere Variante der Erfindung.

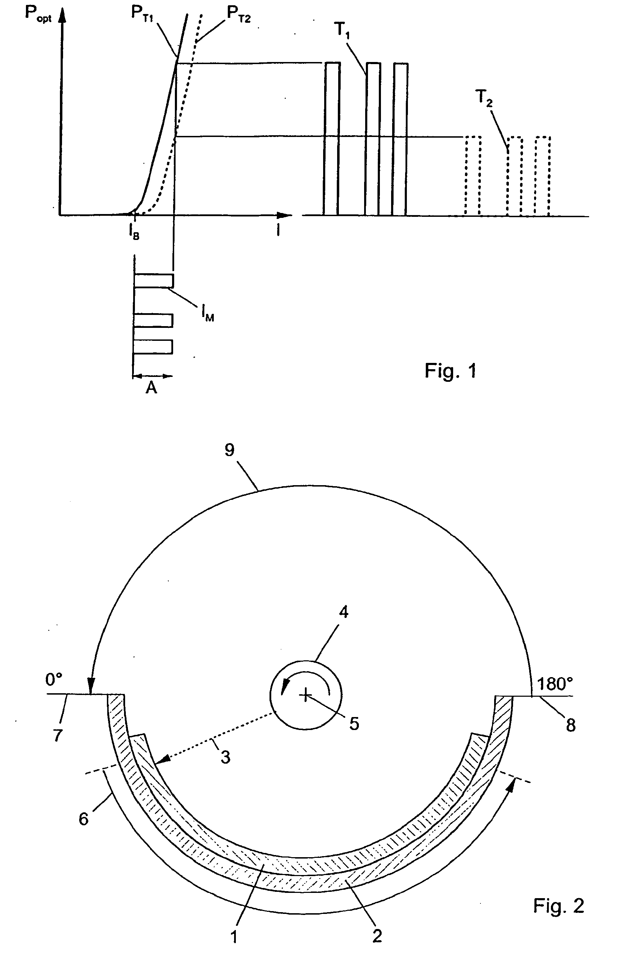

Fig. 1 zeigt die Modulation einer Laserdiode in einem Strom-Leistungs-Diagramm, in dem die optische Ausgangsleistung Pₒₚₜ einer Laserdiode in Abhängigkeit vom Diodenstrom l aufgetragen ist. In Fig. 1 ist eine erste Kurve P_{T1}(I) für eine Temperatur T1 und eine zweite Kurve P_{T2}(I) für eine Temperatur T2 > T1 dargestellt. Die Kurven zeigen das typische Verhalten für eine Laserdiode, d.h. eine Lichtleistung wird erst oberhalb eines Schwellenstroms abgegeben und die Lichtleistung steigt dann mit weiter wachsendem Strom stark an. Bei der höheren Temperatur T2 setzt die Abgabe der Lichtleistung erst bei einem höheren Schwellenstrom ein, d.h. die Kurve P_{T2}(I) ist im wesentlichen gegenüber der Kurve P_{T1}(I) verschoben. Die Modulation der Laserdiode erfolgt üblicherweise durch die Überlagerung eines Basisstroms I_{B} und eines Modulationsstroms I_{M}. Im Fall der Belichtung einer Druckform ist der Modulationsstrom eine Rechtecklmpulsfolge mit der Amplitude A, die das Bildsignal der zu belichtenden und nicht zu belichtenden Bildpunkte wiedergibt. Fig. 1 veranschaulicht, daß man für die Temperatur T1 eine hohe Lichtleistung der Ausgangsimpulse erhält und für die höhere Temperatur T2 eine geringere Lichtleistung.

Fig. 2 zeigt eine Belichtungsvorrichtung im Schnittbild, die nach dem Innentrommel-Prinzip arbeitet. Das Aufzeichnungsmaterial 1 ist an der Innenfläche einer stationären zylindersegmentförmigen Halterung oder Belichtungsmulde 2 mit einem Öffnungswinkel von beispielsweise 180° fixiert. Der von einer nicht dargestellten Laserdiode erzeugte Lichtstrahl 3 wird mit einer rotierenden Lichtstrahl-Ablenkvorrichtung 4 in Richtung eines Pfeils (Zeilenrichtung) auf einer Kreisbahn punkt- und zeilenweise über das Aufzeichnungsmaterial 1 gelenkt, wobei die Laserdiode mit der Überlagerung des Basisstroms lB und des Modulationsstroms I_{M} moduliert wird und sich die Lichtstrahl-Ablenkvorrichtung 4 in Richtung der Zylinderachse 5 senkrecht zur Zeichenebene (Vorschubrichtung) bewegt. Die Lichtstrahl-Ablenkvorrichtung 4 ist beispielsweise ein schräg zur Zylinderachse 5 orientierter Spiegel, der sich um die Zylinderachse 5 dreht. Innerhalb der Belichtungsmulde 2 erstreckt sich über das Aufzeichnungsmaterial 1 ein Belichtungsbereich 6. Der Belichtungsbereich 6 kennzeichnet in jeder Belichtungsperiode (Zeile) den Belichtungszeitraum bzw. Modulationszeitraum, in dem der Lichtstrahl 3 die Belichtung einer Zeile auf dem Aufzeichnungsmaterial 1 vornimmt. Der Belichtungsbereich 6 ergibt sich aus der Zeilenlänge der zu belichtenden Druckform und kann je nach dem Format der Druckseite kleiner als die verfügbare Breite des Aufzeichnungsmaterials sein. Der Belichtungsbereich 6 beginnt hinter einer Anfangsmarkierung 7 bei dem Öffnungswinkel 0° und endet vor einer Endmarkierung 8 bei dem Öffnungswinkel 180°. Ein Rückführungsbereich 9, der bei der eingetragenen Pfeilrichtung an der Endmarkierung 8 beginnt und an der Anfangsmarkierung 7 endet, kennzeichnet den Rückführungszeitraum, in dem keine Belichtung stattfindet und der Lichtstahl 3 jeweils zur nächsten Zeile geführt wird.

Die erfindungsgemäße Temparaturstabilisierung wird nachfolgend näher erläutert.

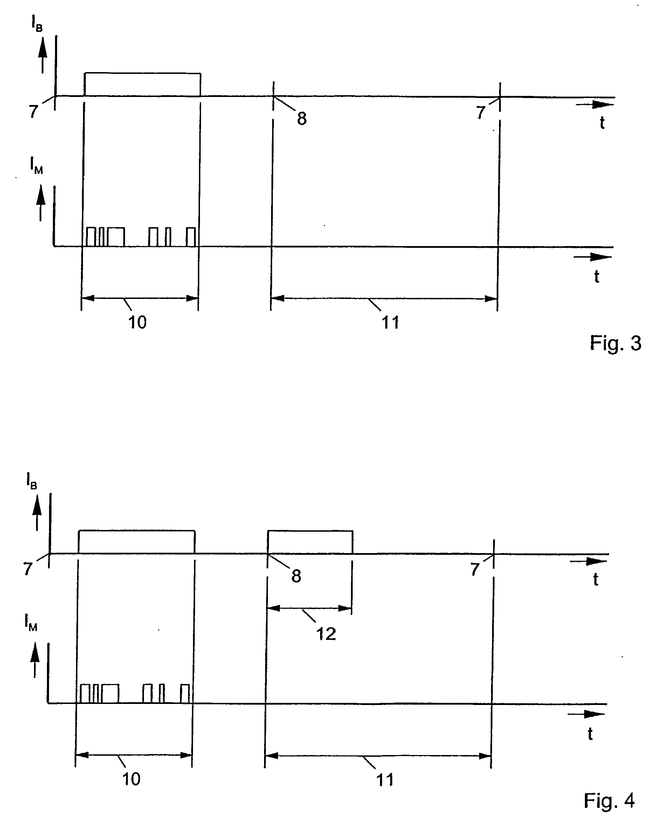

Fig. 3 zeigt Zeitdiagramme zur Veranschaulichung des zeitlichen Verlaufes des Basisstroms I_{B} und des Modulationsstroms I_{M} nach dem Stand der Technik ohne die erfindungsgemäße Temperaturstabilisierung. In dem Zeitintervall, in dem sich der Lichtstrahl 3 zwischen der Anfangsmarkierung 7 und der Endmarkierung 8 befindet, wird der Basisstrom I_{B} während eines Belichtungszeitraums 10 eingeschaltet, in dem sich der Lichtstrahl im Belichtungsbereich 6 befindet. Zusätzlich wird der aus dem Bildsignal abgeleitete Modulationsstrom I_{M} überlagert. Der Basisstrom I_{B} wird erst während des Belichtungszeitraums 10 eingeschaltet, weil die Laserdiode auch schon beim Basisstrom eine geringe Lichtleistung abgeben kann. Wenn der Basisstrom außerhalb des Belichtungszeitraums 10 eingeschaltet würde, könnte eine nicht gewünschte Belichtung des Aufzeichnungsmaterials 1 außerhalb des Druckformformats erfolgen.

In dem Zeitintervall, in dem sich der Lichtstrahl 3 zwischen der Endmarkierung 8 und der Anfangsmarkierung 7 befindet, d.h. in dem Rückführungszeitraum 11, der dem Rückführungsbereich 9 entspricht, werden nach dem Stand der Technik weder der Basisstrom I_{B} noch der Modulationsstrom I_{M} eingeschaltet. Dadurch kommt es zu einer Absenkung der Betriebstemperatur der Laserdiode während des Rückführungszeitraums 11.

Fig. 4 zeigt Zeitdiagramme zur Veranschaulichung der thermischen Stabilisierung der Laserdiode nach dem erfindungsgemäßen Verfahren. Innerhalb des Rückführungszeitraums 11 ist ein Stabilisierungszeitraum 12 vorgesehen, in dem der Basisstrom I_{B} zusätzlich eingeschaltet wird, um die Laserdiode auch während des Rückführungszeitraums 11 zu erwärmen und die Temperaturabsenkung zu vermeiden. Obwohl die Laserdiode beim Basisstrom I_{B} allein keine oder nur eine sehr geringe optische Leistung abgibt, wird doch eine Verlustleistung aufgenommen, die im wesentlichen gleich der durch Strom und Spannung an der Diode bestimmten Gesamtleistung ist und die die Laserdiode erwärmt. Die in Fig. 1 dargestellte abgegebene optische Leistung Pₒₚₜ ist bei typischen Laserdioden nur ein kleiner Bruchteil der aufgenommenen Gesamtleistung. Die Länge des Stabilisierungszeitraums 12 wird vorzugsweise so gewählt, daß die Summe aus Belichtungszeitraum 10 und Stabilisierungszeitraum 12 für alle Zeilenlängen, die sich aus den unterschiedlichen Formaten der belichteten Druckformen ergeben, konstant bleibt, d.h. beispielsweise der maximal möglichen Zeilenlänge entspricht. Das heißt, für eine Druckform mit einer großen Zeilenlänge wird der Stabilisierungszeitraum 12 entsprechend kürzer gewählt als für eine Druckform mit einer kleinen Zeilenlänge. Dadurch ist der Basisstrom unabhängig vom Format der belichteten Druckform während einer vollen Umdrehung der Lichtstrahl-Ablenkvorrichtung 4 immer gleich lange eingeschaltet, wodurch die Betriebstemperatur der Laserdiode stabilisiert wird. In der Praxis ist für eine ausreichende Stabilisierung der Betriebstemperatur oft jedoch keine exakte Konstanz der Einschaltdauer des Basisstroms erforderlich.

Abweichend von dem in Fig. 4 gezeigten Zeitverlauf kann die zeitliche Lage des Stabilisierungszeitraums 12 innerhalb des Rückführungszeitraums 11 auch variiert werden.

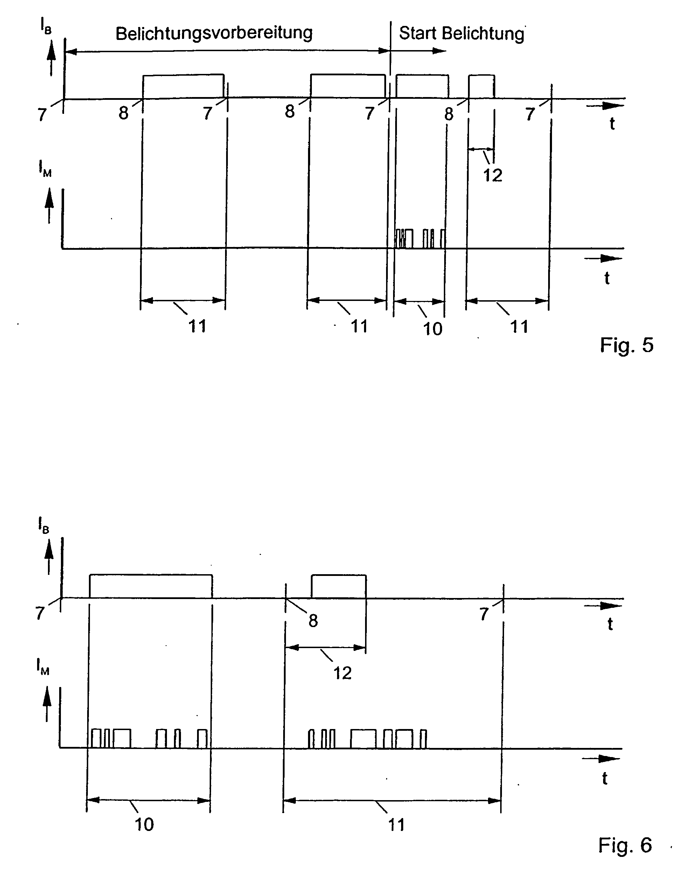

Nach einem weiteren Merkmal der Erfindung wird der Basisstrom I_{B} bereits eingeschaltet, bevor die erste Zeile der Druckform belichtet wird, um die Laserdiode auf eine vorgegebene Betriebstemperatur zu bringen. In einem Innentrommelrecorder wird die Lichtstrahl-Ablenkvorrichtung 4 vor dem Belichtungsstart auf ihre Solldrehzahl gebracht, und der Vorschubantrieb, der die Lichtstrahl-Ablenkvorrichtung 4 entlang der Zylinderachse 5 bewegt, wird auf seine Sollgeschwindigkeit gebracht. Während dieser Phase der Belichtungsvorbereitung wird der Basisstrom nur während des Rückführungszeitraums 11 eingeschaltet, wobei die Einschaltdauer vorzugsweise entsprechend der festgelegten Summe aus Belichtungszeitraum 10 und Stabilisierungszeitraum 12 gewählt wird, also beispielsweise der maximal möglichen Zeilenlänge entspricht. Fig. 5 zeigt den Zeitablauf dazu. Mit der Belichtung der ersten Zeile wird dann die Einschaltdauer des Basisstroms I_{B} entsprechend dem in Fig. 4 dargestellten Zeitverlauf auf den Belichtungszeitraum 10 und den Stabilisierungszeitraum 12 verteilt. Durch das Einschalten des Basisstroms schon während der Belichtungsvorbereitung wird erreicht, daß sich die Laserdiode mit dem Beginn der Belichtung bereits in einem thermischen Gleichgewichtszustand befindet.

Die gleiche Maßnahme wird erfindungsgemäß angewendet, wenn der Recorder im sogenannten Start/Stop-Betrieb arbeitet. Ein Recorder muß immer dann im Start/Stop-Betrieb betrieben werden, wenn nicht sichergestellt ist, daß der zur Aufbereitung des Bildsignals vorhandene Rechner, auch Raster-lmage-Prozessor (RIP) genannt, das Bildsignal zur Modulation des Lichtstrahls kontinuierlich mit der erforderlichen Geschwindigkeit zur Verfügung stellen kann. Treten Verzögerungen bei der Bereitstellung des Bildsignal für die folgenden zu belichtenden Zeilen auf, wird der Vorschubantrieb des Recorders angehalten, bis für die nachfolgenden Zeilen das Bildsignal zur Verfügung steht. Dann muß der Vorschubantrieb wegen der Trägheit der zu bewegenden Massen ein Stück zurückfahren und wieder anlaufen, bis er auf seine Sollgeschwindigkeit gebracht ist. Während der Anhaltephase und der Wiederanlaufphase wird der Basisstrom I_{B} nur während des Rückführungszeitraums 11 und dann entsprechend länger eingeschaltet, um die Laserdiode während der Wartezeit im thermischen Gleichgewicht zu halten. Durch das vollständige Verschieben des Basisstroms in den Rückführungszeitraum 11 wird verhindert, daß die möglicherweise auch beim Basisstrom abgegebene geringe Lichtleistung der Laserdiode während der Anhaltephase akkumuliert wird und zu einer Belichtung des Aufzeichnungsmaterials führt.

Nach einem weiteren Merkmal der Erfindung kann die thermische Stabilisierung der Laserdiode noch weiter verbessert werden, wenn während des Rückführungszeitraums 11 zusätzlich auch der Modulationsstrom I_{M} eingeschaltet wird. Vorzugsweise wird dabei die Laserdiode mit dem invertierten Bildsignal der vorangegangenen oder der folgenden Zeile moduliert. Fig. 6 zeigt dazu den Zeitablauf. Durch die Modulation mit dem invertierten Bildsignal wird erreicht, daß während einer vollen Umdrehung der Lichtstrahl-Ablenkvorrichung 4 die Laserdiode zu gleichlangen Zeitanteilen den Basisstrom I_{B} und den maximalen Strom I_{Max} = I_{B} + A führt. Dadurch ist die Leistungsaufnahme der Laserdiode während einer vollen Umdrehung der Lichtstrahl-Ablenkvorrichtung 4 konstant, unabhängig von der Form des Modulationsstroms I_{M}, d.h. unabhängig vom Bildinhalt der belichteten Zeile.

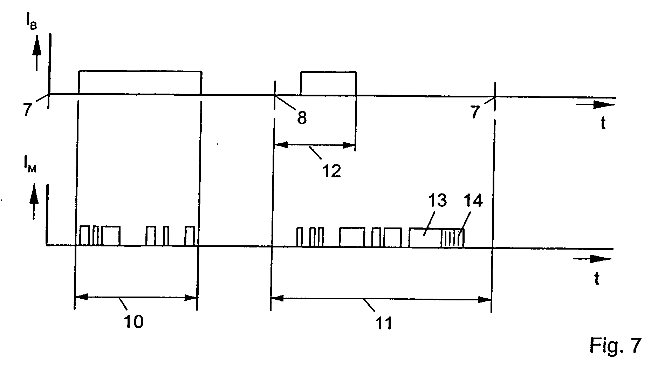

Fig. 7 zeigt eine Variante dieses Prinzips. Hier ist der Modulationsstrom I_{M} auf die maximal mögliche Zeilenlänge verlängert worden, indem der Signalteil 13 angefügt wurde. Auch hierbei ist die Leistungsaufnahme der Laserdiode während einer vollen Umdrehung der Lichtstrahl-Ablenkvorrichtung 4 konstant, unabhängig von der Form des Modulationsstroms I_{M}, hat aber einen höheren Wert als bei der Variante nach Fig. 6. Die Wirkung der Variante nach Fig. 7 kann noch weiter optimiert werden, wenn der angefügte Signalteil 13 um einen Zeitanteil 14 gekürzt wird, der die abgestrahlte Lichtleistung während des Belichtungszeitraums 10 und des Stabilisierungszeitraums 12 kompensiert. Da die thermische Verlustleistung gleich der aufgenommenen Gesamtleistung abzüglich der abgestrahlten Lichtleistung ist, ist dann die thermische Verlustleistung während einer vollen Umdrehung der Lichtstrahl-Ablenkvorrichtung 4 konstant.

## Patentansprüche

1. Verfahren zur thermischen Stabilisierung einer Laserdiode in einem Recorder, bei dem
- mit einer Laserdiode ein Lichtstrahl (3) erzeugt wird,
- die Laserdiode durch die Überlagerung eines Basisstroms (I_{B}) und eines Modulationsstroms (I_{M}) moduliert wird, und
- Aufzeichnungsmaterial (1) durch den modulierten Lichtstrahl (3) punkt- und zeilenweise belichtet wird, wobei zwischen den Belichtungszeiträumen (10), in denen jeweils eine Zeile belichtet wird, Rückführungszeiträume (11) vorhanden sind, in denen der Lichtstrahl (3) an den Anfang der nächsten Zeile geführt wird,
**dadurch gekennzeichnet,**
**dass** der Basisstrom (I_{B}) der Laserdiode innerhalb des jeweiligen Rückführungszeitraums (11) eingeschaltet wird.

2. Verfahren nach Anspruch 1,
**dadurch gekennzeichnet,**
**dass** der Basisstrom (I_{B}) der Laserdiode während eines Stabilisierungszeitraums (12) innerhalb des jeweiligen Rückführungszeitraums (11) wenigstens zeitweise eingeschaltet wird.

3. Verfahren nach Anspruch 1 oder 2,
**dadurch gekennzeichnet,**
**dass** die Summe der Einschaltdauern des Basisstroms (I_{B}) während eines Belichtungszeitraums (10) und während des jeweiligen Stabilisierungszeitraums (12) konstant ist.

4. Verfahren nach Anspruch 3,
**dadurch gekennzeichnet,**
**dass** die Summe der Einschaltdauern des Basisstroms (I_{B}) während eines Belichtungszeitraums (10) und während des jeweiligen Stabilisierungszeitraums (12) der maximale belichtbaren Zeilenlänge entspricht.

5. Verfahren nach einem der Ansprüche 1 bis 4,
**dadurch gekennzeichnet,**
**dass** der Basisstrom (I_{B}) der Laserdiode vor der Belichtung der ersten Zeile während eines Rückführungszeitraums (11) eingeschaltet wird.

6. Verfahren nach einem der Ansprüche 1 bis 4,
**dadurch gekennzeichnet,**
**dass** bei einer Start/Stop-Detriebsart des Recorders der Basisstrom (I_{B}) der Laserdiode während einer Anhaltephase und einer Wiederanlaufphase während des jeweiligen Rückführzeitraums (11) eingeschaltet wird.

7. Verfahren nach einem der Ansprüche 1 bis 4,
**dadurch gekennzeichnet,**
**dass** während des jeweiligen Rückführungszeitraums (11) die Laserdiode zusätzlich mit einem Modulationsstrom (I_{M}) moduliert wird.

8. Verfahren nach Anspruch 7,
**dadurch gekennzeichnet,**
**dass** der Modulationsstrom (I_{M}) aus dem invertierten Bildsignal der vorangegangenen oder der nachfolgenden Zeile abgeleitet wird.

9. Verfahren nach einem der Ansprüche 7 bis 8,
**dadurch gekennzeichnet,**
**dass** der Modulationsstrom (I_{M}) um einen angefügten Signalteil (13) auf die maximal mögliche Zeilenlänge verlängert wird.

10. Verfahren nach Anspruch 9,
**dadurch gekennzeichnet,**
**dass** der angefügt Signalteil (13) um einen Zeitanteil (14) gekürzt wird, der der abgestrahlten Lichtleistung der Laserdiode während eines Belichtungszeitraums (10) und des jeweiligen Stabilisierungszeitraums (12) entspricht.

11. Verfahren nach einem der Ansprüche 1 bis 10,
**dadurch gekennzeichnet,**
**dass** der Recorder ein Innentrommel-Recorder ist.

## Claims

1. A method for thermal stabilization of a laser diode in a recorder, which comprises:
- generating a light beam (3) with a laser diode;
- modulating the laser diode by superimposing a basic current (I_{B}) and a modulation current (I_{M}); and
- exposing a recording material (1) point by point and line by line with the modulated light beam (3), wherein during exposure periods (10) a respective line is exposed, and return periods (11) exist during which the light beam (3) is guided to the start of the next line, **characterized in that** during the respective return period (11), the basic current (I_{B}) of the laser diode is switched on.

2. The method according to claim 1, **characterized in that** the basic current (I_{B}) of the laser diode is at least some of the time switched on during a stabilization period (12) within said respective return period (11).

3. The method according to claim 1 or 2, **characterized in that** the sum of ON times of the basic current (I_{B}) during an exposure period (10) and during the respective stabilization period (12) is constant.

4. The method according to claim 3, **characterized in that** the sum of ON times of the basic current (I_{B}) during an exposure period (10) and during the respective stabilization period (12) corresponds to the maximum line length that can be exposed.

5. The method according to one of the claims 1 to 4, **characterized in that** the basic current (I_{B}) of the laser diode is switched on during a return period (11) before a first line is exposed.

6. The method according to one of the claims 1 to 4, **characterized in that** in a start/stop operating mode of the recorder the basic current (I_{B}) of the laser diode is switched on during the respective return period (11), during a stop phase and during a restarting phase.

7. The method according to one of the claims 1 to 4, **characterized in that** the laser diode is additionally modulated with a modulation current (I_{M}) during the respective return period (11).

8. The method according to claim 7, **characterized in that** the modulation current (I_{M}) is derived from the inverted image signal from the preceding or the following line.

9. The method according to one of the claims 7 to 8, **characterized in that** the modulation current (I_{M}) is lengthened to the maximum possible line length with an appended signal component (13).

10. The method according to claim 9, **characterized in that** the appended signal component (13) is shortened by a proportion of a time (14) corresponding to the emitted light power from the laser diode during an exposure period (1) and the respective stabilization period (12).

11. The method according to one of the claims 1 to 10, **characterized in that** the recorder is an inner drum recorder.

## Revendications

1. Procédé pour la stabilisation thermique d'une diode laser dans un enregistreur, pour lequel
- un rayon lumineux (3) est généré par une diode laser
- la diode laser est modulée par la superposition d'un courant de base (I_{B}) et un courant de modulation (I_{M}) et
- le matériel d'enregistrement (1) étant exposé au rayon lumineux modulé (3) point par point et ligne par ligne, entre les périodes d'exposition (10), dans lesquelles une ligne est exposée respectivement, des périodes de retour (11) existant dans lesquelles le rayon lumineux (3) est guidé au début de la ligne suivante, **caractérisé en ce que** le courant de base (I_{B}) de la diode laser est mis sous tension pendant la période respective de retour (11).

2. Procédé selon la revendication 1, **caractérisé en ce que** le courant de base (I_{B}) de la diode laser est mis sous tension pendant une période de stabilisation (12) à l'intérieur de la période respective de retour (11) au moins par intermittence.

3. Procédé selon la revendication 1 ou 2, **caractérisé en ce que** la somme des durées de mise sous tension du courant de base (I_{B}) pendant une période d'exposition (10) et pendant la période respective de stabilisation (12) est constante

4. Procédé selon la revendication 3, **caractérisé en ce que** la somme des durées de mise sous tension du courant de base (I_{B}) pendant une période d'exposition (10) et pendant la période respective de stabilisation (12) correspond à la longueur de ligne maximale pouvant être exposée.

5. Procédé selon l'une des revendications 1 à 4, **caractérisé en ce que** le courant de base (I_{B}) de la diode laser est mis sous tension avant l'exposition de la première ligne pendant une période de retour (11).

6. Procédé selon l'une des revendications 1 à 4, **caractérisé en ce que** dans un mode de service Start/Stop de l'enregistreur, le courant de base (I_{B}) de la diode laser est mis sous tension pendant une phase de pause et une phase de redémarrage pendant la période de retour (11).

7. Procédé selon l'une des revendications 1 à 4, **caractérisé en ce que** pendant la période respective de retour (11), la diode laser est modulée en supplément avec un courant de modulation (I_{M}).

8. Procédé selon la revendication 7, **caractérisé en ce que** le courant de modulation (I_{M}) est dérivé du signal d'image inversé de la ligne précédente ou suivante.

9. Procédé selon l'une des revendications 7 à 8, **caractérisé en ce que** le courant de modulation (I_{M}) est allongé d'une partie de signal ajoutée (13) à la longueur de ligne maximale possible.

10. Procédé selon la revendication 9, **caractérisé en ce que** la partie de signal ajoutée est raccourcie d'une partie temporelle (14) qui correspond à la puissance lumineuse émise de la diode laser pendant une période d'exposition (10) et une période respective de stabilisation (12).

11. Procédé selon l'une des revendications 1 à 10, **caractérisé en ce que** l'enregistreur est un enregistreur à tambour interne.
